(19) **Europäisches Patentamt / European Patent Office / Office européen des brevets**

(11) **EP 4 727 022 A1**

(12) **EUROPEAN PATENT APPLICATION**

(43) Date of publication:
**15.04.2026 Bulletin 2026/16**

(51) International Patent Classification (IPC):
**H04B 1/525** (2015.01)

(21) Application number: **25206292.2**

(22) Date of filing: **02.10.2025**

(52) Cooperative Patent Classification (CPC):
**H04B 1/525**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **14.10.2024 KR 20240139725**

(71) Applicant: **Samsung Electronics Co., Ltd.**
**Suwon-si, Gyeonggi-do 16677 (KR)**

(72) Inventors:
• **KIM, Daeyoung**
**16677 Suwon-si (KR)**
• **YU, Hyunseok**
**16677 Suwon-si (KR)**

(74) Representative: **Marks & Clerk LLP**
**15 Fetter Lane**
**London EC4A 1BW (GB)**

(54) **INTERFERENCE CANCELLATION CIRCUIT AND OPERATION METHOD THEREOF**

(57) An interference cancellation circuit includes a magnitude and phase calculator configured to receive one or more input signals and calculate magnitudes and phases of the one or more input signals, a phase reconfiguration circuit configured to output an interference phase by reconfiguring the phases of the one or more input signals, based on an interference model, and a weight estimator configured to estimate a weight of an interference signal, based on the magnitudes of the one or more input signals. The interference cancellation circuit is configured to output the interference signal, based on the interference phase, the magnitudes of the one or more input signals, and the weight. A phase of the kernel model associated with the interference model is different from the phases of the one or more input signals.

FIG. 3

**Description**

BACKGROUND

The present disclosure relates to an interference cancellation circuit and an operation method thereof, and more particularly, to an interference cancellation circuit for canceling self-interference of a transmission signal, and an operation method of the interference cancellation circuit.

A wireless communication system may employ various techniques to increase throughput. For example, a wireless communication system may employ carrier aggregation (CA), E-UTRA-UTRA NR network dual connectivity (EN-DC), multiple-input and multiple-output (MIMO), and the like, which increase communication capacity by using a plurality of antennas. With the employment of techniques for increasing throughput, transmitting sides may transmit signals with high complexity and receiving sides may be required to process the signals with high complexity.

An interference signal may hinder the receiving side from processing a signal received through an antenna, and the interference signal may be generated in various ways. For example, the interference signal may include inter-cell interference, which is a signal received from a neighboring base station at a boundary of a serving base station, intra-cell interference, which corresponds to a radio signal from another terminal within coverage of a serving base station, channel interference, and the like.

In addition to the interference signal received through the antenna, there is also an interference signal generated by a transmission signal leaked to a reception path or coupled onto the reception path within a terminal. In the case of a self-interference signal generated within the terminal, the power-amplified transmission signal is fed back as an interference signal as it is, which may have a great impact on the deterioration of reception sensitivity. Accordingly, there is a need for a method of more efficiently canceling a self-interference signal generated within the terminal. Moreover, when a plurality of transmission signals are independently transmitted according to transmission techniques such as CA, EN-DC, and MIMO, transmission frequencies of the plurality of transmission signals may be different from each other, and interference due to intermodulation between the transmission signals of different frequencies may additionally occur. Therefore, there is a need for a method of canceling interference caused by intermodulation.

SUMMARY

Embodiments provide an interference cancellation circuit and an operation method thereof, and more particularly, to an interference cancellation circuit for canceling self-interference of a transmission signal, and an operation method of the interference cancellation circuit. While self-interference is described, embodiments may not be limited to cancelling self-interference, but may apply more generally to interference.

According to an aspect of the disclosure, there is provided an interference cancellation circuit including a magnitude and phase calculator configured to receive one or more input signals and calculate magnitudes and phases of the one or more input signals, a phase reconfiguration circuit configured to output an interference phase by reconfiguring the phases of the one or more input signals, based on an interference model, and a weight estimator configured to estimate a weight of an interference signal, based on the magnitudes of the one or more input signals. The interference cancellation circuit is configured to output the interference signal, based on the interference phase, the magnitudes of the one or more input signals, and the weight. A phase of the kernel model associated with the interference model may be different from the phases of the one or more input signals.

According to another aspect of the disclosure, there is provided an operation method of an interference cancellation circuit, the operation method including receiving one or more input signals and calculating respective magnitudes and respective phases of the one or more input signals, generating an interference phase by reconfiguring the respective phases of the one or more input signals, based on an interference model, estimating a weight of an interference signal, based on the magnitudes of the one or more input signals, and outputting the interference signal, based on the interference phase, the magnitudes of the one or more input signals, and the weight. A phase of the kernel model associated with the interference model may be different from the phases of the one or more input signals.

According to another aspect of the inventive concept, there is provided an interference cancellation circuit including a plurality of sub-interference cancellation circuits each configured to receive one or more input signals corresponding to a memory order and output a sub-interference signal corresponding to the memory order, wherein the plurality of sub-interference cancellation circuits include a magnitude and phase calculator configured to calculate respective magnitudes and respective phases of the one or more input signals, a phase reconfiguration circuit configured to output an interference phase by reconfiguring the respective phases of the one or more input signals, based on an interference model, a segment index selector configured to select an index corresponding to the magnitudes of the one or more input signals, and a weight selector configured to select a weight for the sub-interference signal, based on the index. The interference cancellation circuit is configured to generate an interference signal by summing all of the sub-interference signals. A phase of the kernel model associated with the interference model may be different from the phases of the one or more input signals.

At least some of the above and other features of the disclosure are set out in the claims.

BRIEF DESCRIPTION OF THE DRAWINGS

The above and/or other aspects will be more clearly understood from the following detailed description taken in conjunction with the accompanying drawings, in which:

FIG. 1 is a diagram illustrating an example of self-interference due to a transmission signal;
FIG. 2 is a schematic diagram illustrating a wireless communication device according to an embodiment;
FIG. 3 is a block diagram of an interference cancellation circuit according to an embodiment;
FIG. 4 is a block diagram of an interference cancellation circuit that outputs an interference signal for one input signal, according to an embodiment;
FIG. 5 is a table showing a kernel phase function according to an interference model for one input signal, according to an embodiment;
FIG. 6 is a block diagram of an interference cancellation circuit that outputs an interference signal for two input signals, according to an embodiment;
FIG. 7 is a table showing a kernel phase function according to an interference model for two input signals, according to an embodiment;
FIG. 8 is a block diagram of an interference cancellation circuit that outputs an interference signal for one input signal, according to an embodiment;
FIG. 9 is a block diagram of an interference cancellation circuit that outputs an interference signal for two input signals, according to an embodiment;
FIG. 10A is a table showing H2, IMD3, and IMD3+IMD5 interference models;
FIG. 10B is a graph showing performance of an interference cancellation circuit according to an embodiment for an H2 interference model;
FIG. 10C is a graph showing an interference cancellation circuit according to an embodiment for an IMD3 interference model;
FIG. 10D is a graph showing an interference cancellation circuit according to an embodiment for an IMD3+IMD5 interference model;
FIG. 11 is a flowchart of an operation method of an interference cancellation circuit, according to an embodiment; and
FIG. 12 is a block diagram of a wireless communication device according to an embodiment.

DETAILED DESCRIPTION

Hereinafter, example embodiments are described with reference to the accompanying drawings.

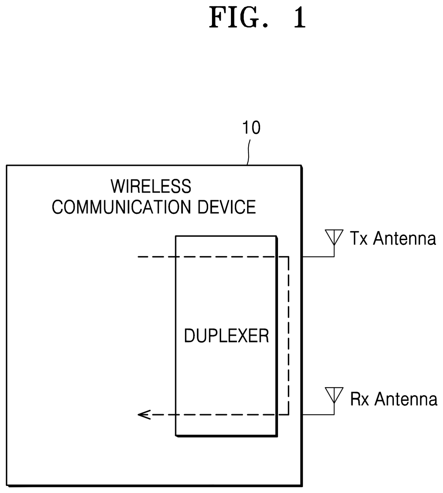

FIG. 1 is a diagram illustrating an example of self-interference due to a transmission signal.
Referring to FIG. 1, a wireless communication device 10 may include a transmission antenna and a reception antenna. A single antenna may be connected to both a transmission radio frequency (RF) chain and a reception RF chain through a duplexer. For example, the wireless communication device 10 may receive a wireless signal through the reception RF chain in a receiving mode, and may transmit a baseband signal to an external device through the transmission RF chain in a transmitting mode. A RF chain may comprise electronic components and/or circuits configured to transmit (or receive) an RF signal.
According to various embodiments, in the case of the wireless communication device 10 including the transmission antenna and the reception antenna connected to each other through the duplexer, feedback of a transmission signal based on the transmission antenna and the reception antenna adjacent to each other may occur. However, because the duplexer is connected to both the transmission RF chain and the reception RF chain, at least a portion of the transmission signal from the transmission RF chain may be leaked to the reception RF chain. When the leaked signal is input to the reception RF chain, self-interference may occur.
According to various embodiments, the reception antenna may receive a wireless signal transmitted by the transmission antenna as well as a wireless signal transmitted by the external device. For example, when the transmission antenna and the reception antenna correspond to omnidirectional antennas and the transmission antenna and the reception antenna are arranged adjacent to each other, some of the transmitted wireless signals may be fed back through the reception antenna. Self-interference may also occur based on the fed-back wireless signals.

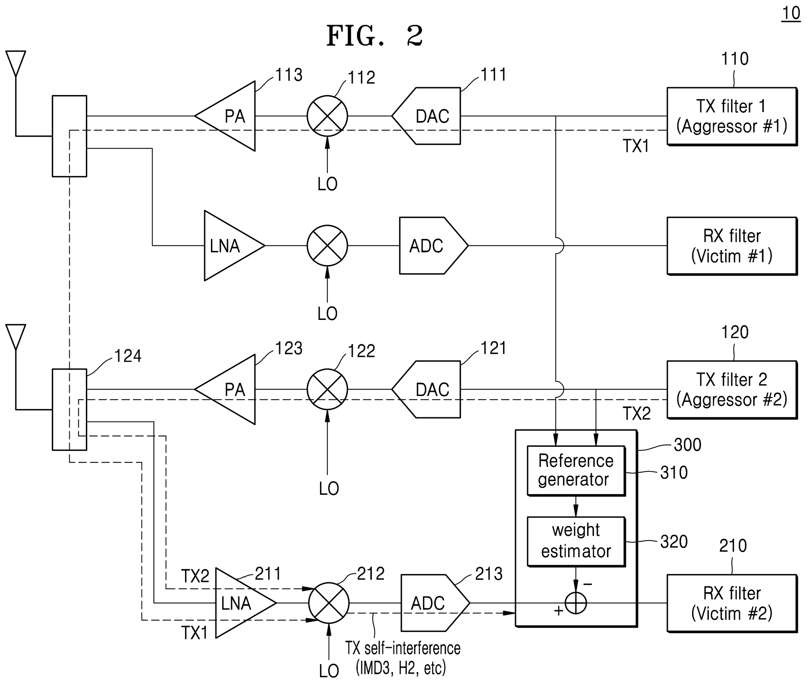

FIG. 2 is a schematic diagram illustrating the wireless communication device 10 according to an embodiment.
Referring to FIG. 2, a first transmission signal TX1 and a second transmission signal TX2 may be transmitted. That is, the wireless communication device 10 may be equipped with two antennas, and the two antennas may be antennas for transmitting and receiving signals. The wireless communication device 10 may include various numbers of antennas, and is not limited to the embodiment of FIG. 2.

For example, a desired frequency band may be filtered from the first transmission signal TX1 through a first transmission filter 110, and the first transmission signal TX1 may be converted from a digital signal into an analog signal through a first digital-to-analog converter (DAC) 111. Next, a transmission frequency of the first transmission signal TX1 may be up-converted by a local oscillator (LO) frequency received from an LO through a first mixer 112. The first transmission signal TX1 may be amplified through a first power amplifier (PA) 113, and then may be transmitted to an external device (e.g., a base station) through an antenna. A desired frequency band may be filtered from the second transmission signal TX2 through a second transmission filter 120, and the second transmission signal TX2 may be converted from a digital signal into an analog signal through a second DAC 121. Next, a transmission frequency of the second transmission signal TX2 may be up-converted by an LO frequency received by a second mixer 122. The second transmission signal TX2 may be amplified through a second PA 123, and then may be transmitted to the external device through an antenna.

According to various embodiments, the wireless communication device 10 may perform carrier aggregation or dual connectivity, and all of the first transmission filter 110, the second transmission filter 120, and a reception filter 210 may be in an on state. In this case, when self-interference occurs, the first transmission signal TX1 amplified through the first PA 113 may be coupled onto a neighboring reception RF chain. For example, the first transmission signal TX1 may be input as a reception signal to a low noise amplifier (LNA) 211 of the reception RF chain. The second transmission signal TX2 may leak from a transmission RF chain connected through a duplexer 124. That is, the second transmission signal TX2 may be input as a reception signal to the LNA 211 through the duplexer 124. The first transmission signal TX1 and the second transmission signal TX2 may generate an interference signal near a reception frequency due to nonlinear characteristics of the reception RF chain, the first transmission signal TX1 and the second transmission signal TX2 may be down-converted again by an LO frequency received by a third mixer 212, and may be converted into a digital signal through an analog-to-digital converter (ADC) 213. Thereafter, the interference signal generated by the first transmission signal TX1 and the second transmission signal TX2 may be canceled through the interference cancellation circuit 300.

The interference cancellation circuit 300 may include a reference generator 310 and a weight estimator 320. The reference generator 310 may be a circuit configured to receive the interference signal (e.g., the first transmission signal TX1 and the second transmission signal TX2) and reproduce (or regenerate) an interference model. The reproduced interference model can include both an active interference signal and a passive interference signal. The weight estimator 320 may estimate coefficients of a reference generated by the reference generator 310. The weight estimator 320 may generate the interference signal by estimating the coefficients (e.g., parameters and weights) of the reference, and may filter the interference signal by adding or subtracting the interference signal to or from the reception signal. In regard to this functional aspect, the weight estimator 320 may be referred to as an adaptive filter.

For example, the weight estimator 320 may be based on one of adaptive filter algorithms, such as a least mean square (LMS) algorithm using a stochastic gradient descent method, a recursive least squares (RLS) algorithm, or a dichotomous coordinate descent (DCD)-RLS algorithm.

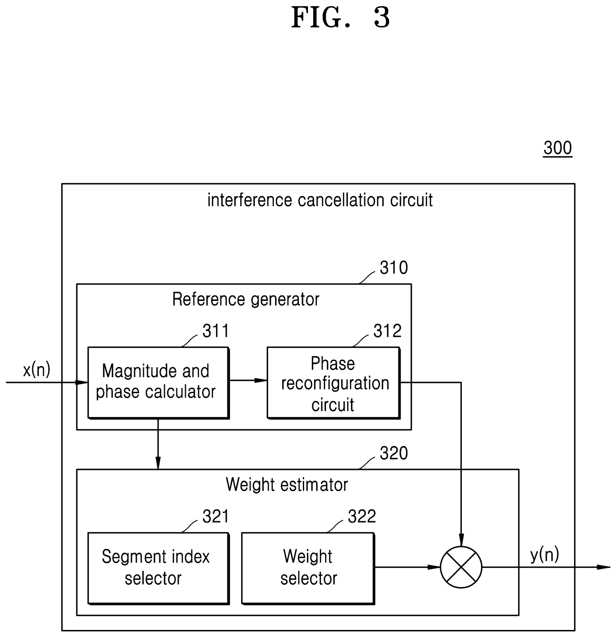

FIG. 3 is a block diagram of an interference cancellation circuit 300 according to an embodiment.

The interference cancellation circuit 300 of FIG. 3 may correspond to the interference cancellation circuit 300 of FIG. 2. Referring to FIG. 3, the interference cancellation circuit 300 includes a reference generator 310 and a weight estimator 320. The reference generator 310 includes a magnitude and phase calculator 311 and a phase reconfiguration circuit 312. The weight estimator 320 includes a segment index selector 321 and a weight selector 322. The weight estimator 320 may further include a multiplier. Unlike what is shown in FIG. 3, the multiplier may be located outside the weight estimator 320.

The reference generator 310 may receive an input signal x(n). Referring to FIG. 2, the input signal x(n) may include the first transmission signal TX1 and the second transmission signal TX2. In detail, the magnitude and phase calculator 311 of the reference generator 310 may receive the input signal x(n) and calculate a phase and a magnitude of the input signal x(n). A delay signal (e.g., x(n-m)) (where m is an integer) may be input as an input signal to the reference generator 310. The magnitude and phase calculator 311 may calculate the magnitude and phase of the input signal x(n). The interference cancellation circuit 300 may further include a delay circuit, and the delay circuit may generate the delay signal x(n-m) by delaying the input signal x(n) by m in terms of time. The magnitude and phase calculator 311 may calculate the phase and the magnitude of the delay signal x(n-m).

The magnitude and phase calculator 311 may transmit the phase of the input signal x(n) to the phase reconfiguration circuit 312. The phase reconfiguration circuit 312 may reconfigure (convert) the phase of the input signal x(n), based on the interference model. Accordingly, the interference cancellation circuit 300 may consider a phase change in interference caused due to intermodulation, while estimating the interference model based on a magnitude selective affine (MSA) model. For example, the phase reconfiguration circuit 312 may output an interference phase by reconfiguring the phase of the input signal x(n) to be identical to the phase of a kernel model. The kernel model may refer to a linear combination model for the interference model.

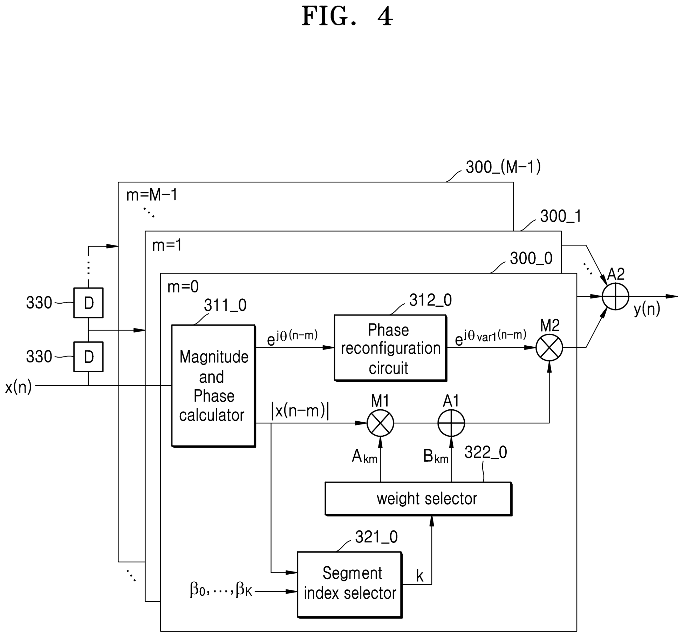

The magnitude and phase calculator 311 may transmit the magnitude of the input signal x(n) to the weight estimator 320. The magnitude of the input signal x(n) may be input to the segment index selector 321. The segment index selector 321 may select an index for weight selection, based on the magnitude of the input signal x(n). The segment index selector 321 may transmit the selected index to the weight selector 322. The weight selector 322 may select a weight, based on the selected index. A weight and a coefficient may be used interchangeably. In other words, the weight may be referred to as the coefficient. According to an embodiment, the weight selector 322 may compute an affine function by using the selected weight and the magnitude of the input signal x(n). According to another embodiment, as in interference cancellation circuits of FIGS. 4, 6, 8, and 9, affine function computation may be performed outside the weight selector 322. Referring to FIG. 3, the weight estimator 320 may generate an interference signal y(n) by multiplying the calculated affine function by the reconfigured phase.

The interference cancellation circuit 300 may perform filtering of the interference signal y(n) by adding or subtracting the interference signal y(n) to or from the reception signal.

The interference cancellation circuit 300 according to an embodiment includes the magnitude and phase calculator 311 that receives one or more input signals and calculates magnitudes and phases of the one or more input signals, the phase reconfiguration circuit 312 that outputs an interference phase by reconfiguring the phases of the one or more input signals, based on an interference model, and the weight estimator 320 that estimates a weight of an interference signal, based on the magnitudes of the one or more input signals. The interference cancellation circuit 300 is configured to output the interference signal, based on the interference phase, the magnitudes of the one or more input signals, and the weight. A phase of the kernel model associated with the interference model may be different from the phases of the one or more input signals. For example, the interference model and the kernel model may be understood with reference to Table 1 below.

[Table 1]

| Non-linear model (interference model) | Input signal and kernel model | Phase characteristics |
|---|---|---|
| Transmission Self-interference (TX self-interference) (e.g., 2nd harmonic , 3rd harmonic , IMD2, and IMD3) | Input signal: $x(n)$ 2nd harmonic kernel model: Linear coupling of $|x(n)|^p x(n)^2$ | A phase of an input signal and a phase of an input signal are different from each other. |

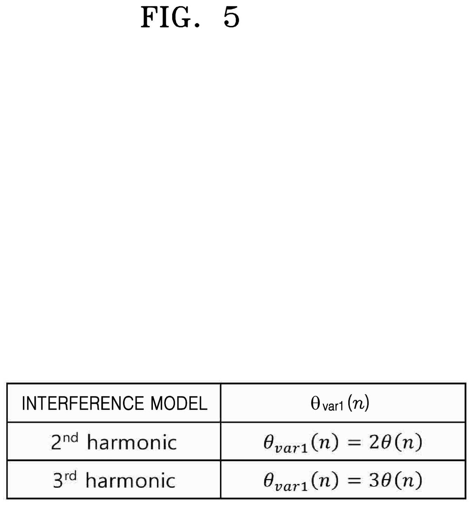

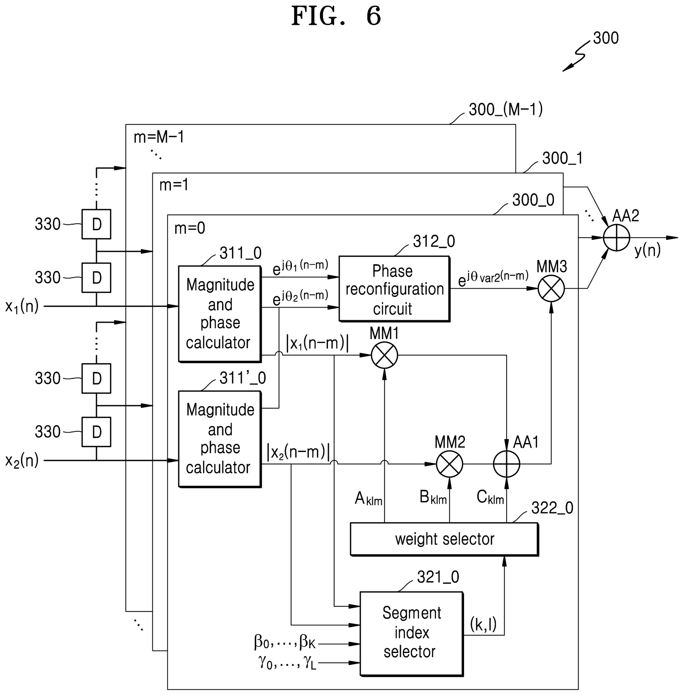

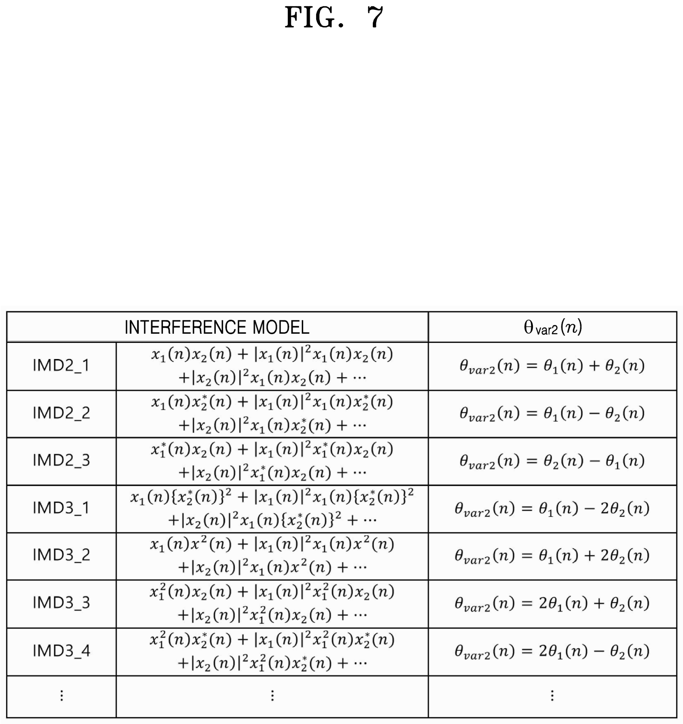

According to an embodiment, the phase reconfiguration circuit 312 may output the interference phase by reconfiguring the phases of the one or more input signals to be identical to the phase of the kernel model. The weight may include a plurality of segments. The weight estimator 320 may select an index for one of a plurality of segments corresponding to the magnitudes of the one or more input signals, and may determine the weight, based on the index. When the one or more input signals are one input signal, the interference model may include a 2nd harmonic and a 3rd harmonic. When the interference model is the 2nd harmonic, the phase reconfiguration circuit 312 may double a function for the phases of the one or more input signals (see FIG. 5). When the interference model is the 3rd harmonic, the phase reconfiguration circuit 312 may triple a function for the phases of the one or more input signals (see FIG. 5). When the one or more input signals include a first input signal and a second input signal, the interference model may include intermodulation distortion 2 (IMD2), intermodulation distortion 3 (IMD3), intermodulation distortion 4 (IMD4), and intermodulation distortion 5 (IMD5). The interference model may include sub-interference models based on a combination of the first input signal, a conjugate signal of the first input signal, a second input signal, and a conjugate signal of the second input signal (see FIG. 7). The interference cancellation circuit 300 may further include a plurality of sub-interference cancellation circuits having different memory orders (see FIGS. 4 and 6). Each of the plurality of sub-interference cancellation circuits may include at least one magnitude and phase calculator, a phase reconfiguration circuit, and a weight estimator, and may be configured to output a sub-interference signal corresponding to a memory order, based on the interference phase, the magnitudes of the one or more input signals, and the weight. The interference cancellation circuit 300 is configured to output the interference signal by summing all of the sub-interference signals. The interference cancellation circuit 300 may be configured to delay the one or more input signals by an amount corresponding to the memory order and input a result of the delaying as the one or more input signals to the plurality of sub-interference cancellation circuits.

FIG. 4 is a block diagram of an interference cancellation circuit that outputs an interference signal for one input signal, according to an embodiment.

In detail, FIG. 4 illustrates an example of the interference cancellation circuit 300 associated with a case where a single input signal, such as a 2nd harmonic or a 3rd harmonic, acts as interference. FIG. 4 may be described with reference to FIGS. 1 through 3, and a description of FIG. 4 that is the same as given above with reference to FIGS. 1 through 3 will not be repeated herein.

Referring to FIG. 4, the interference cancellation circuit 300 may include M sub-interference cancellation circuits 300_0 through 300_(M-1). M is a positive integer, and represents a memory order. Each of the sub-interference cancellation circuits 300_0 through 300_(M-1) includes a magnitude and phase calculator, a phase reconfiguration circuit, a segment index selector, and a weight selector. For convenience of explanation, the sub-interference cancellation circuit 300_0 when a memory order is 0 (m=0) will now be described, and descriptions of the sub-interference cancellation circuits 300_1 through 300_(M-1) when memory orders are 1 through (M-1) will be omitted.

The interference cancellation circuit 300 may receive one input signal x(n), and may estimate an interference model generated by the one input signal x(n). That is, the interference cancellation circuit 300 may receive a single variable as the input signal x(n) and output an interference signal y(n) for the single variable.

The interference signal y(n) may be expressed as in Equation 1 below, and the input signal x(n) may be expressed as in Equation 2 below.

[Equation 1]

$$y(n) = \sum_{m-0}^{M-1} (A_{km}|x(n-m)| + B_{km})e^{j\theta_{var1}(n-m)}$$

$$\text{For each } m,$$
$$\text{if } \beta_{k-1} \le |x(n-m)| < \beta_k, k = 1, \dots, K$$
$$\text{then select } A_{km}, B_{km}$$

[Equation 2]

$$x(n) = |x(n)|e^{j\theta(n)}$$

In Equations 1 and 2, y(n) indicates an interference signal (output signal). x(n) indicates an input signal. $\beta_k$ indicates a segment threshold. M indicates a memory order. K indicates a total number of segments. k indicates a segment index. m is a positive integer. Each sub-interference cancellation circuit is indexed by m, thus m may be referred to as a memory index. There are in total M such circuits, and M is referred to as the memory order. Taken together, there are M memory indices. x(n-m) is a signal obtained by delaying the input signal x(n) by m in terms of time. $A_{km}$ and $B_{km}$ indicate weights (coefficients). $\theta_{var1}(n - m)$ indicates a kernel phase function. The kernel phase function $\theta_{var1}$ (n - m) may vary according to interference models. The segment index k that satisfies a segment $\beta_{k-1} \le |x(n-m)| \le \beta_k$) to which a magnitude | x(n - m)| of the input signal belongs may be determined. The coefficients $A_{km}$ and $B_{km}$ may be switched according to k. $\theta_{var1}$ (n - m) indicates a phase function modified to fit the interference model by using the phase of the input signal x(n). Because the interference model of Equation 1 is an interference model based on magnitude selective affine (MSA) among universal approximators, the number of terms does not change even when a nonlinear order increases. Accordingly, the interference cancellation circuit 300 operates like a universal approximator, leading to low complexity and low power consumption. Modeling by a universal approximator is a method of dividing a nonlinear model into a plurality of segments and modeling the plurality of segments into a linear function. For example, the modeling by a universal approximator includes canonical piecewise linear (CPWL), decomposed vector rotation (DVR), and MSA. Although it is described that the interference cancellation circuit 300 based on an MSA model, embodiments are not limited thereto, and may be applied to an interference model by the above-described universal approximator. An operation of the interference cancellation circuit 300 will now be described in detail with respect to Equation 1.

A magnitude and phase calculator 311_0 of the sub-interference cancellation circuit 300_0 may receive the input signal x(n) and calculate a phase and a magnitude of the input signal x(n). The interference cancellation circuit 300 may further include delay circuits 330. The delay circuits 330 may delay the input signal x(n) by m. The delay circuits 330 may transmit an input signal x(n-m) resulting from the delaying of the input signal x(n) by m to a magnitude and phase calculator of an m-th sub-interference cancellation circuit 300_m. For example, the delay circuits 330 may transmit a delayed input signal x(n-1) (i.e., m=1) to a magnitude and phase calculator 311_1 of the sub-interference cancellation circuit 300_1.

The magnitude and phase calculator 311_0 may calculate the magnitude and phase of the input signal x(n-m) (where m=0). Hereinafter, in a description of the sub-interference cancellation circuit 300_0, m is 0. The magnitude and phase calculator 311_0 may transmit the phase $e^{j\theta(n-m)}$ of the input signal x(n) to a phase reconfiguration circuit 312_0. The phase reconfiguration circuit 312_0 may output a phase $e^{j\theta_{var1}(n-m)}$ of the interference signal y(n) by reconfiguring (converting) the phase of the input signal x(n), based on the interference model. Accordingly, the interference cancellation circuit 300 may consider a phase change in interference caused due to intermodulation, while estimating the interference model based on MSA.

The magnitude and phase calculator 311_0 may transmit a magnitude $|x(n - m)|$ of the input signal x(n) to the segment index selector 321_0 (where m=0). The magnitude $|x(n - m)|$ of the input signal x(n) may be input to the segment index selector 321_0 The segment index selector 321_0 may select an index k for selecting the weights $A_{km}$ and $B_{km}$, based on the magnitude $|x(n - m)|$ of the input signal x(n). The segment index selector 321_0 may input segment thresholds $\beta_0, ... , \beta_K$ according to k. The segment index selector 321_0 may transmit the selected index k to the weight selector 322_0. The weight selector 322_0 may select the weights $A_{km}$ and $B_{km}$, based on the selected index k. The sub-interference cancellation circuit 300_0 may further include a multiplier M1, a multiplier M2, and an adder A1. The sub-interference cancellation circuit 300_0 may calculate an affine function by using the selected weights $B_{km}$ and $|x(n - m)|$ and the magnitude $A_{km}$ of the input signal x(n). The sub-interference cancellation circuit 300_0 may generate a sub-interference signal by multiplying the calculated affine function $A_{km}|x(n - m)| + B_{km}$ and the reconfigured phase $e^{j\theta_{var1}(n-m)}$. The interference cancellation circuit 300 may further include an adder A2. The interference cancellation circuit 300 may output the interference signal y(n) by summing all of sub-interference signals output by the sub-interference cancellation circuits 300_0 through 300_(M-1). Referring to FIG. 4, the multiplier M1 and the adder A1 may be located outside the weight selector 322_0. However, the multiplier M1 and the adder A1 may be included in the weight selector 322_0.

The interference cancellation circuit 300 may perform filtering of the interference signal y(n) by adding or subtracting the interference signal y(n) to or from the reception signal.

FIG. 5 is a table showing a kernel phase function according to an interference model for one input signal, according to an embodiment.

FIG. 5 will be described with reference to FIG. 4. Referring to FIG. 5, for a 2nd harmonic interference model, the kernel phase function may be expressed as in Equation 3 below.

$$[\text{Equation 3}]$$

$$\theta_{var1}(n) = 2\theta(n)$$

For a 3rd harmonic interference model, the kernel phase function may be expressed as in Equation 4 below.

$$[\text{Equation 4}]$$

$$\theta_{var1}(n) = 3\theta(n)$$

As described above with reference to FIG. 4, a kernel phase function $\theta_{var1}(n)$ is a phase function modified according to an interference model (e.g., 2nd harmonic or 3rd harmonic) by using the phase of the input signal x(n). Accordingly, the interference cancellation circuit 300 may model an interference signal in a system in which the phase of an interference signal is different from the phase of an input signal.

FIG. 6 is a block diagram of an interference cancellation circuit that outputs an interference signal for two input signals, according to an embodiment.

In detail, FIG. 6 illustrates an example of an interference cancellation circuit 300 associated with a case where two input signals act as interference, like IMD2 or IMD3.

Referring to FIG. 6, the interference cancellation circuit 300 may include M sub-interference cancellation circuits 300_0 through 300_(M-1). M is a positive integer, and represents a memory order. Each of the sub-interference cancellation circuits 300_0 through 300_(M-1) includes a magnitude and phase calculator, a phase reconfiguration circuit, a segment index selector, and a weight selector. For convenience of explanation, the sub-interference cancellation circuit 300_0 when a memory order is 0 (m=0) will now be described, and descriptions of the sub-interference cancellation circuits 300_1 through 300_(M-1) when memory orders are 1 through (M-1) will be omitted.

The interference cancellation circuit 300 may receive two input signals $x_1(n)$ and $x_2(n)$, and may estimate an interference model generated by the two input signals $x_1(n)$ and $x_2(n)$. That is, the interference cancellation circuit 300 may receive the two input signals $x_1(n)$ and $x_2(n)$, and may output the interference signal y(n) for a dual variable.

The interference signal y(n) and the two input signals $x_1(n)$ and $x_2(n)$ may be expressed as in Equations 5 and 6 below.

[Equation 5]

$$y(n) = \sum_{m=0}^{M-1} (A_{klm}|x_1(n-m)| + B_{klm}|x_2(n-m)| + C_{klm})e^{j\theta_{var2}(n-m)}$$

For each $m$,

if $(\beta_{k-1} \le |x_1(n-m)| < \beta_k)$ & $(\gamma_{l-1} \le |x_2(n-m)| < \gamma_l)$

$$k = 1, ..., K, \; l = 1, ..., L$$

then select $A_{klm}, B_{klm}, C_{klm}$

[Equation 6]

$$x_1(n) = |x_1(n)|e^{j\theta_1(n)}, x_2(n) = |x_2(n)|e^{j\theta_2(n)}$$

In Equations 5 and 6, y(n) indicates an interference signal (output signal). $x_1(n)$ indicates a first input signal, and $x_2(n)$ indicates a second input signal. $\beta_k$ indicates a segment threshold for the magnitude of the first input signal $x_1(n)$. $\gamma_l$ indicates a segment threshold for the magnitude of the second input signal $x_2(n)$. M indicates a memory order. K indicates the total number of segments for the first input signal $x_1(n)$. k indicates a segment index for the first input signal $x_1(n)$. L indicates the total number of segments for the second input signal $x_2(n)$. The total number of segments is K * L. l indicates a segment index for the second input signal $x_2(n)$. m is a positive integer, and $A_{klm}$, $B_{klm}$, and $C_{klm}$ indicate weights (coefficients). $\theta_{var2}(n-m)$ indicates a kernel phase function. The kernel phase function $\theta_{var2}(n-m)$ may vary according to interference models. A 2-dimension (D) segment index (k, 1) that simultaneously satisfies a segment $\beta_{k-1} \le |x_1(n-m)| \le \beta_k$ to which the magnitude $|x_1(n-m)|$ of the first input signal belongs and a segment $\gamma_{l-1} \le |x_2(n-m)| < \gamma_l$ to which the magnitude $|x_2(n-m)|$ of the second input signal belongs may be determined. According to k and l, the coefficients $A_{klm}$, $B_{klm}$, and $C_{klm}$ may be switched. $\theta_{var2}(n-m)$ is a phase function modified appropriately for the interference model by using the phases of the first and second input signals $x_1(n)$ and $x_2(n)$. Because the interference model of Equation 5 is an interference model based on an MSA model among universal approximators, the number of terms does not change even when a nonlinear order increases. Accordingly, the interference cancellation circuit 300 operates like a universal approximator, leading to low complexity and low power consumption. An operation of the interference cancellation circuit 300 will now be described in detail with respect to Equation 5.

A magnitude and phase calculator 311_0 of the sub-interference cancellation circuit 300_0 may receive the first input signal $x_1(n)$ and calculate a phase and a magnitude of the first input signal $x_1(n)$. The interference cancellation circuit 300 may further include delay circuits 330. The delay circuits 330 may delay the first input signal $x_1(n)$ by m. The delay circuits 330 may transmit a first input signal $x_1(n-m)$ resulting from the delaying of the first input signal x1(n) by m to a magnitude and phase calculator of an m-th sub-interference cancellation circuit 300_m. For example, the delay circuits 330 may transmit a delayed first input signal $x_1(n-1)$ (i.e., m=1) to a magnitude and phase calculator 311_0 of the sub-interference cancellation circuit 300_1.

A magnitude and phase calculator 311'_0 of the sub-interference cancellation circuit 300_0 may receive the second input signal $x_2(n)$ and calculate the phase and the magnitude of the second input signal $x_2(n)$. The delay circuits 330 may delay the second input signal $x_2(n)$ by m. The delay circuits 330 may transmit a second input signal $x_2(n-m)$ resulting from the delaying of the second input signal $x_2(n)$ by m to the magnitude and phase calculator of the m-th sub-interference cancellation circuit 300_m. For example, the delay circuits 330 may transmit a delayed second input signal $x_2(n-1)$ (i.e., m=1) to a magnitude and phase calculator 311'_0 of the sub-interference cancellation circuit 300_1.

The magnitude and phase calculator 311_0 may calculate the magnitude and phase of the first input signal $x_1(n-m)$ (where m=0). Hereinafter, in a description of the sub-interference cancellation circuit 300_0, m is 0. The magnitude and phase calculator 311_0 may transmit a phase $e^{j\theta_1(n-m)}$ of the first input signal $x_1(n)$ to the phase reconfiguration circuit 312_0. The magnitude and phase calculator 311'_0 may calculate the magnitude and phase of the second input signal $x_2(n-m)$. The magnitude and phase calculator 311_0 may transmit a phase $e^{j\theta_2(n-m)}$ of the second input signal $x_2(n)$ to the phase reconfiguration circuit 312_0. The phase reconfiguration circuit 312_0 may output a phase $e^{j\theta_{var2}(n-m)}$ of the interference signal y(n) by reconfiguring (converting) the phases of the first input signal $x_1(n)$ and the second input signal $x_2(n)$, based on the interference model. Accordingly, the interference cancellation circuit 300 may consider a phase change in interference caused due to intermodulation, while estimating the interference model based on an MSA model.

The magnitude and phase calculator 311_0 may transmit a magnitude $|x_1(n-m)|$ of the first input signal $x_1(n)$ to the segment index selector 321_0. The magnitude $|x_1(n-m)|$ of the first input signal $x_1(n)$ may be input to the segment index selector 321_0. The magnitude and phase calculator 311'_0 may transmit a magnitude $|x_2(n-m)|$ of the second input signal $x_2(n)$ to the segment index selector 321_0. The magnitude $|x_2(n-m)|$ of the second input signal $x_2(n)$ may be input to the segment index selector 321_0.

The segment index selector 321_0 may select the 2-D index (k,l) for selecting the weights $A_{klm}$, $B_{klm}$, and $C_{klm}$, based on the magnitude $|x_1(n-m)|$ of the first input signal x1(n) and the magnitude $|x_2(n-m)|$ of the second input signal $x_2(n)$. The segment index selector 321_0 may input segment thresholds $\beta_0, \dots, \beta_K, \gamma_0, \dots, \gamma_L$. The segment index selector 321_0 may transmit the selected 2-D index (k,l) to the weight selector 322_0. The weight selector 322_0 may select the weights $A_{klm}$, $B_{klm}$, and $C_{klm}$, based on the selected 2-D index (k,l). The sub-interference cancellation circuit 300_0 may further include multipliers MM1, MM2, and MM3 and an adder AA1. The sub-interference cancellation circuit 300_0 may calculate an affine function by using the selected weights $A_{klm}$, $B_{klm}$, and $C_{klm}$, the magnitude $|x_1(n-m)|$ of the first input signal x1(n) and the magnitude $|x_2(n-m)|$ of the second input signal $x_2(n)$. The sub-interference cancellation circuit 300_0 may generate a sub-interference signal by multiplying the calculated affine function $A_{klm}|x_1(n-m)|+B_{klm}|x_2(n-m)|+C_{klm}$ by the reconfigured phase $e^{j\theta var2(n-m)}$. The interference cancellation circuit 300 may further include an adder AA2. The interference cancellation circuit 300 may output the interference signal y(n) by summing all of sub-interference signals output by the sub-interference cancellation circuits 300_0 through 300_(M-1). Referring to FIG. 6, multipliers MM1 and MM2 and the adder AA1 may be located outside the weight selector 322_0. However, the multipliers MM1 and MM2 and the adder AA1 may be included in the weight selector 322_0.

The interference cancellation circuit 300 may perform filtering of the interference signal y(n) by adding or subtracting the interference signal y(n) to or from the reception signal.

FIG. 7 is a table showing a kernel phase function according to an interference model for two input signals, according to an embodiment.

FIG. 7 will be described with reference to FIG. 6. Referring to FIG. 7, an IMD2 interference model may be subdivided into IMD2_1, IMD2_2, and IMD2_3. IMD2_1 may be an interference model associated with a product of the first and second input signals x1(n) and x2(n). IMD2_2 may be an interference model associated with a product of the first input signal x1(n) and a conjugate signal x2*(n) of the second input signal x2(n). IMD2_3 may be an interference model associated with a product of the second input signal x2(n) and a conjugate signal x1*(n) of the first input signal x1(n). An IMD3 interference model may be subdivided into IMD3_1, IMD3_2, IMD3_3, and IMD3_4. A method of the subdivision is similar to IMD2, and redundant explanations thereof are omitted.

Although omitted in FIG. 7, even in the case of IMD4 or higher, an interference model and a kernel phase function may be created in the same manner as in FIG. 7. The IMD2 interference model may also be applied to interference models equal to or higher than IMD4 in certain cases.

As described above with reference to FIG. 6, the kernel phase function $\theta_{var2}(n)$ is a phase function modified according to an interference model (e.g., IMD2 or IMD3) by using the phases of the input signals x1(n) and x2(n). Accordingly, the interference cancellation circuit 300 may model an interference signal in a system in which the phase of an interference signal is different from the phases of input signals.

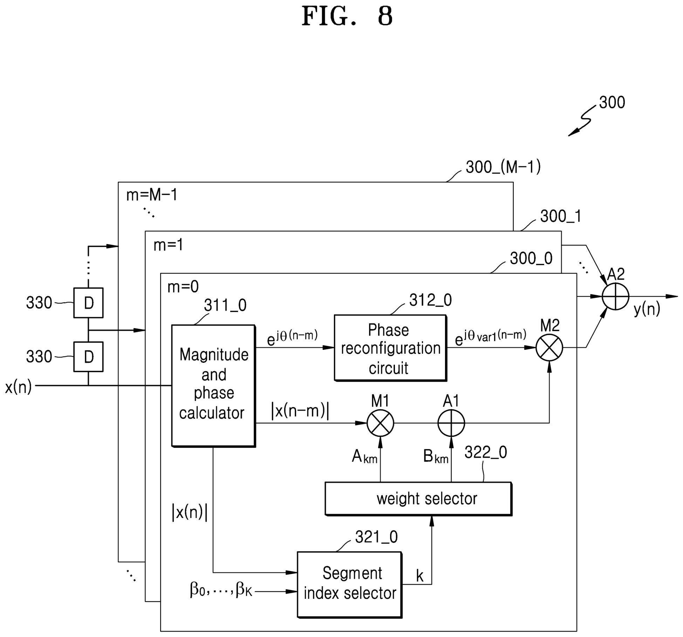

FIG. 8 is a block diagram of an interference cancellation circuit that outputs an interference signal for one input signal, according to an embodiment.

FIG. 8 will be described with reference to FIG. 4. Matters of FIG. 8 that are the same as those of FIG. 4 will not be described here. Referring to FIG. 8, the interference signal y(n) may be expressed as in Equation 7 below.

[Equation 7]

$$y(n) = \sum_{m=0}^{M-1} (A_{km}|x(n-m)| + B_{km})e^{j\theta_{var1}(n-m)}$$
$$\text{For all } m,$$
$$\text{if } \beta_{k-1} \le |x(n)| < \beta_k, k = 1, \dots, K$$
$$\text{then select } A_{km}, B_{km}$$

Unlike Equation 1, in Equation 7, the segment index k may be determined based on the magnitude $|x(n)|$ of the input signal for all memory orders m.

Referring to FIG. 8, the magnitude and phase calculator 311_0 may transmit the magnitude $|x(n)|$ of the input signal to the segment index selector 321_0, and may transmit the magnitude $|x(n-m)|$ (m=0) of the input signal as an input of the multiplier M1. The magnitude and phase calculator 311_m of the sub-interference cancellation circuit 300_m may transmit the magnitude $|x(n)|$ of the input signal to the segment index selector 321_0, and may transmit the magnitude $|x(n-$

*m)|* (m=0) of the input signal as an input of the multiplier M1.

Although the sub-interference cancellation circuit 300_m is not shown in FIG. 8, it will be understood that the sub-interference cancellation circuit 300_m refers to an m-th sub-interference cancellation circuit 300_m among the sub-interference cancellation circuits 300_0 through 300_(M-1). Although the magnitude and phase calculator 311_m is not shown in FIG. 8, it will be understood that the magnitude and phase calculator 311_m refers to an m-th magnitude and phase calculator 311_m among magnitude and phase calculators 311_0 through 311_(M-1).

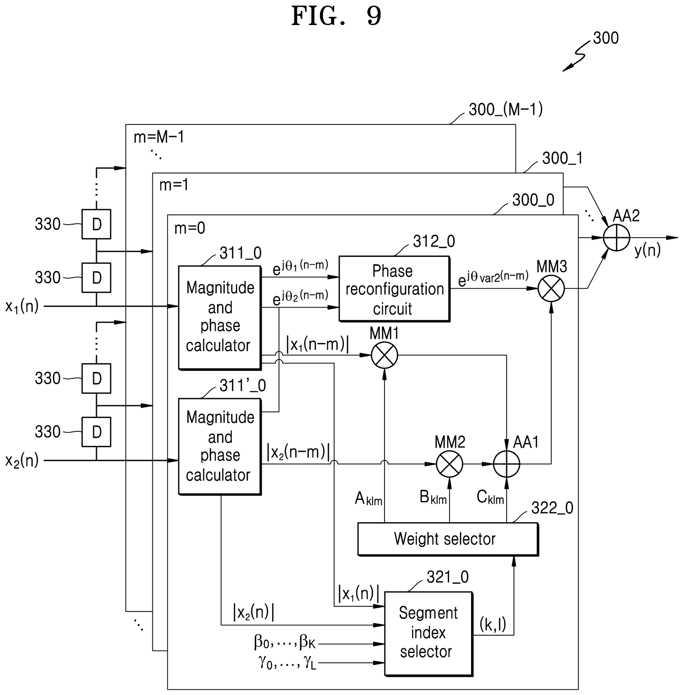

FIG. 9 is a block diagram of an interference cancellation circuit that outputs an interference signal for two input signals, according to an embodiment.

FIG. 9 will be described with reference to FIG. 6. Matters of FIG. 9 that are the same as those of FIG. 6 will not be described here. Referring to FIG. 9, the interference signal y(n) may be expressed as in Equation 8 below.

[Equation 8]

$$y(n) = \sum_{m=0}^{M-1} (A_{klm}|x_1(n-m)| + B_{klm}|x_2(n-m)| + C_{klm})e^{j\theta_{var2}(n-m)}$$

$$\text{For all } m,$$
$$if \ (\beta_{k-1} \leq |x_1(n)| < \beta_k) \ \& \ (\gamma_{l-1} \leq |x_2(n)| < \gamma_l)$$
$$k = 1, \dots, K, \ l = 1, \dots, L$$
$$then \ select \ A_{klm}, B_{klm}, C_{klm}$$

Unlike Equation 5, in Equation 8, the segment index (k,l) may be determined based on the magnitude $|x_1(n)|$ of the first input signal and the magnitude $|x_2(n)|$ of the second input signal, for all of the memory orders m.

Referring to FIG. 9, the magnitude and phase calculator 311_0 may transmit the magnitude $|x_1(n)|$ of the first input signal to the segment index selector 321_0, and may transmit the magnitude $|x(n-m)|$ (m=0) of the input signal as an input of the multiplier MM1. The magnitude and phase calculator 311'_0 may transmit the magnitude $|x_2(n)|$ of the second input signal to the segment index selector 321_0, and may transmit the magnitude $|x_2(n-m)|$ (m=0) of the input signal as an input of the multiplier MM2.

The magnitude and phase calculator 311_m of the m-th sub-interference cancellation circuit 300_m may transmit the magnitude $|x_1(n)|$ of the first input signal to the segment index selector 321_0, and may transmit the magnitude $|x_1(n-m)|$ (m=0) of the input signal as an input of the multiplier MM1. The magnitude and phase calculator 311'_m of the m-th sub-interference cancellation circuit 300_m may transmit the magnitude $|x_2(n)|$ of the second input signal to the segment index selector 321_0, and may transmit the magnitude $|x_2(n-m)|$ of the input signal as an input of the multiplier MM2.

Although a sub-interference cancellation circuit 300_m is not shown in FIG. 9, it will be understood that the sub-interference cancellation circuit 300_m refers to an m-th sub-interference cancellation circuit 300_m among the sub-interference cancellation circuits 300_0 through 300_(M-1). Although the magnitude and phase calculator 311_m and the magnitude and phase calculator 311'_m are not shown in FIG. 9, it will be understood that the magnitude and phase calculator 311_m and the magnitude and phase calculator 311'_m refers to an m-th magnitude and phase calculator 311_m and an m-th magnitude and phase calculator 311'_m among magnitude and phase calculators 311_0 through 311_(M-1) and magnitude and phase calculators 311'_0 through 311'_(M-1).

According to another embodiment, the interference signal y(n) may be expressed as in Equation 9 below.

[Equation 9]

$$y(n) = \sum_{m=0}^{M-1} (A_{klm}|x_1(n-m)| + B_{klm}|x_2(n-d-m)| + C_{klm})e^{j\theta_{var2,d}(n-m)}$$

$$\text{For all } m,$$
$$if \ (\beta_{k-1} \leq |x_1(n)| < \beta_k) \ \& \ (\gamma_{l-1} \leq |x_2(n)| < \gamma_l)$$
$$k = 1, \dots, K, \ l = 1, \dots, L$$
$$then \ select \ A_{klm}, B_{klm}, C_{klm}$$

When a time alignment of the first input signal x1(n) and the second input signal x2(n) is not performed, a delay time d between the first input signal x1(n) and the second input signal x2(n) may be compensated for in the second input signal x2(n), as in Equation 9. In Equation 9, as in Equation 8, the segment index (k,l) may be determined based on the magnitude $|x_1(n)|$ of the first input signal and the magnitude $|x_2(n)|$ of the second input signal, for all of the memory orders m. In Equation 9, $\theta_{var2,d}(n\text{-}m)$ is a phase correction function between the first input signal $x_1(n\text{-}m)$ input to a sub-interference cancellation circuit corresponding to the memory order m and the second input signal $x_2(n\text{-}d\text{-}m)$ input to the sub-interference cancellation circuit corresponding to the memory order m and compensated by d.

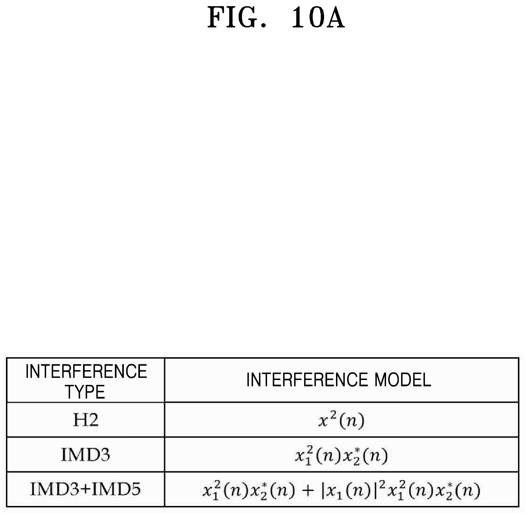

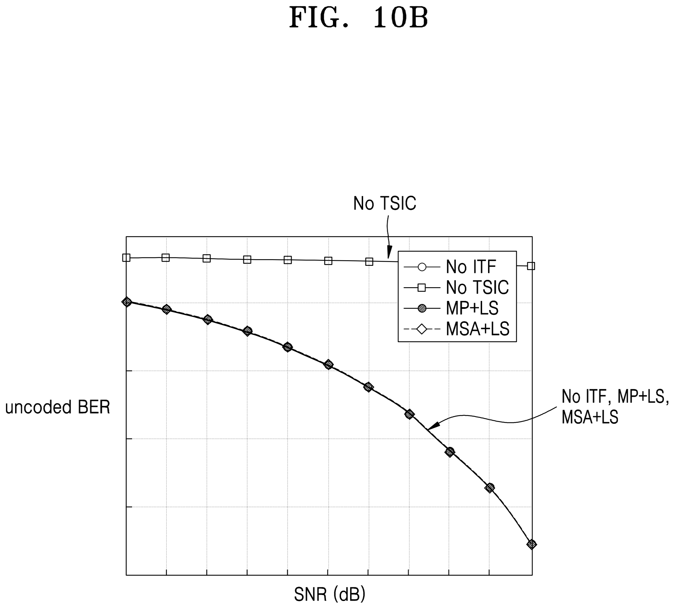

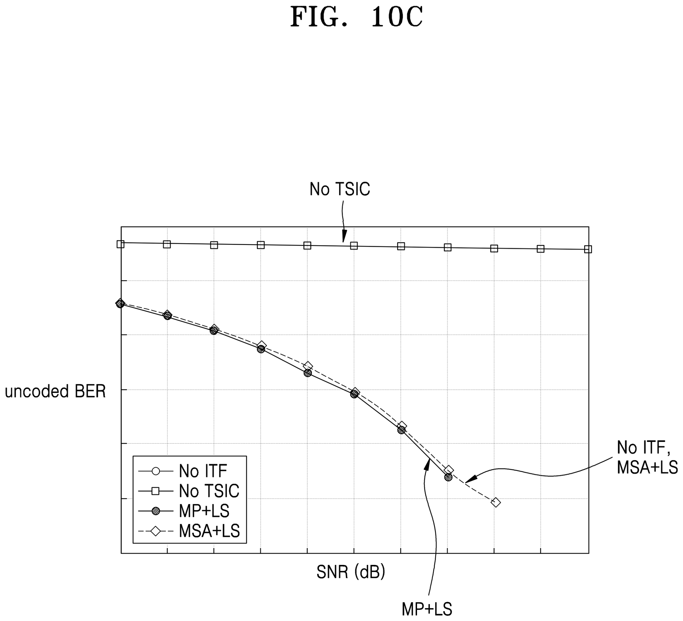

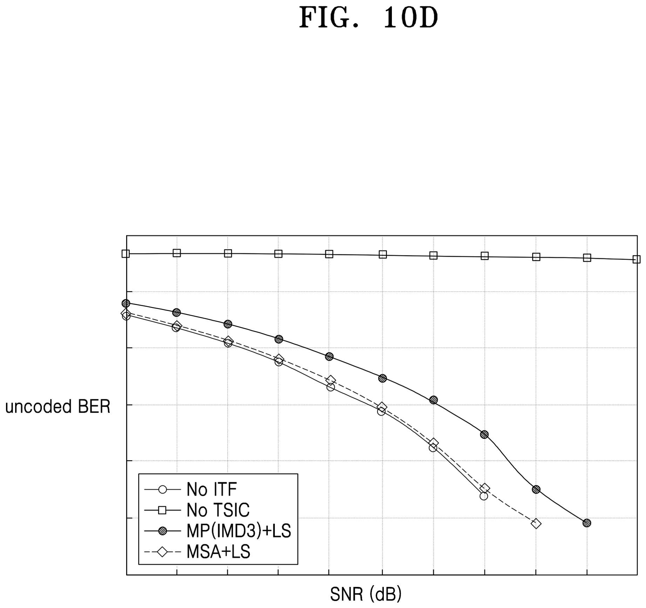

FIG. 10A shows H2, IMD3, and IMD3+IMD5 interference models, FIG. 10B shows the performance of an interference cancellation circuit according to an embodiment for the H2 interference model, FIG. 10C shows the performance of the interference cancellation circuit according to an embodiment for the IMD3 interference model, and FIG. 10D shows the performance of the interference cancellation circuit according to an embodiment for the IMD3+IMD5 interference model.

FIGS. 10A through 10D will now be described with reference to the above-described matters. FIG. 10A illustrates interference models according to the types of interference corresponding to respective situations of FIGS. 10B through 10D. H2 may refer to a 2nd harmonic. That is, in order to verify a modeling performance of an interference cancellation circuit according to an embodiment, it is assumed that the interference models illustrated in FIG. 10A are added to a reception signal, and the performance of the interference cancellation circuit according to an embodiment may be checked by verifying an uncoded bit error ratio (BER) for each of the interference models in FIGS. 10B through 10D.

Referring to FIGS. 10B through 10D, NO ITF refers to a case where there is no interference. NO TSIC refers to a case where there is no interference cancellation circuit, i.e., a case where interference cancellation is not performed. MP+LS refers to a case where interference is canceled by an interference cancellation circuit based on memory polynomial (MP) and least square (LS) methods. MSA+LS is a case where interference has been removed by the interference cancellation circuit based on MSA and LS methods, and refers to a case where interference has been canceled by an interference cancellation circuit according to an embodiment.

Referring to FIG. 10B, for the H2 interference model, the interference cancellation circuit according to an embodiment exhibits the same performance as the interference cancellation circuit based on MP+LS in the absence of interference (respective lines of No ITF, MP+LS, and MSA+LS are overlapped with each other).

Referring to FIG. 10C, for the IMD3 interference model, the interference cancellation circuit according to an embodiment exhibits the same performance as the interference cancellation circuit based on MP+LS in the absence of interference (respective lines of No ITF, MP+LS, and MSA+LS are overlapped with each other).

Referring to FIG. 10D, for the IMD3+IMD5 interference model, the interference cancellation circuit according to an embodiment exhibits almost the same performance as that when there is no interference (respective lines of No ITF and MSA+LS are overlapped with each other). For the IMD3+IMD5 interference model, it may be seen that the interference cancellation circuit according to an embodiment has better performance in terms of a BER than the MP+LS-based interference cancellation circuit. Because the interference cancellation circuit according to an embodiment may perform interference model estimation with respect to high-order nonlinear models having the same phases, it may be seen that there is no performance degradation.

The interference cancellation circuit according to an embodiment may operate like a universal approximator and thus has high performance with respect to nonlinear distortions, such as crest factor reduction (CFR) and ADC hard-limiting.

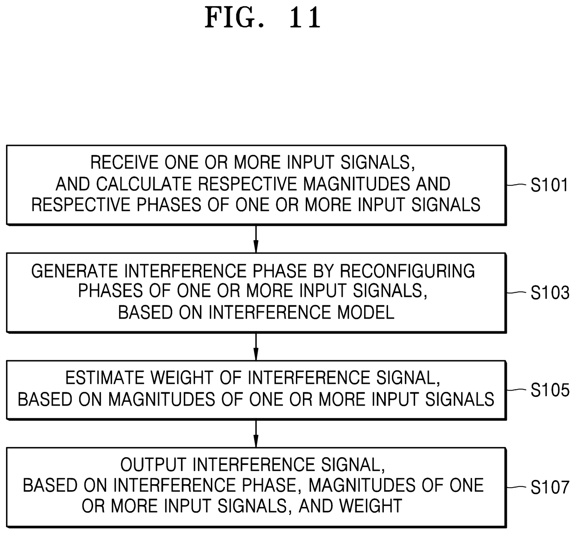

FIG. 11 is a flowchart of an operation method of an interference cancellation circuit according to an embodiment.

Referring to FIG. 11, in operation S101, the interference cancellation circuit may receive one or more input signals, and may calculate respective magnitudes and respective phases of the one or more input signals.

In operation S103, the interference cancellation circuit may generate an interference phase by reconfiguring the phases of the one or more input signals, based on an interference model. A phase of a kernel model associated with the interference model may be different from the phases of the one or more input signals.

According to an embodiment, the interference cancellation circuit may generate the interference phase by reconfiguring the phases of the one or more input signals to be identical to the phase of the kernel model.

When the one or more input signals are one input signal, the interference model may include a 2nd harmonic and a 3rd harmonic. When the interference model includes a 2nd harmonic, the interference cancellation circuit may generate the interference phase by doubling a function for the phases of the one or more input signals. When the interference model includes a 3rd harmonic, the interference cancellation circuit may generate the interference phase by tripling the function for the phases of the one or more input signals.

When the one or more input signals include a first input signal and a second input signal, the interference model may include IMD2, IMD3, IMD4, and IMD5. The interference model may include sub-interference models based on a combination of the first input signal, a conjugate signal of the first input signal, a second input signal, and a conjugate signal of the second input signal.

The phase of the kernel model may be different from the phases of the one or more input signals.

In operation S105, the interference cancellation circuit may estimate a weight of an interference signal, based on the magnitudes of the one or more input signals. The weight may include a plurality of segments. According to an embodiment, the interference cancellation circuit may select an index for one of a plurality of segments corresponding to the magnitudes of the one or more input signals. The interference cancellation circuit may determine the weight, based on the index.

In operation S107, the interference cancellation circuit may output the interference signal, based on the interference phase, the magnitudes of the one or more input signals, and the weight.

The interference cancellation circuit may perform the operation S101 of calculating respective magnitudes and respective phases of the one or more input signals for each memory order, the operation S103 of generating the interference phase, and the operation S105 of estimating the weight.

The interference cancellation circuit may generate sub-interference signals, based on the interference phase, the magnitudes of the one or more input signals, and the weight for each memory order. The interference cancellation circuit may generate the interference signal by summing all of the sub-interference signals, and may output the generated interference signal.

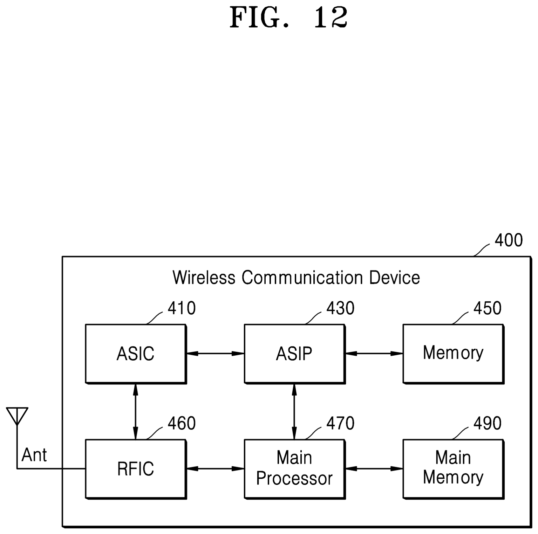

FIG. 12 is a block diagram of a wireless communication device 400 according to an embodiment.

The wireless communication device 400 of FIG. 12 may correspond to the wireless communication device 10 of FIG. 2, and a redundant description thereof will be omitted.

Referring to FIG. 12, the wireless communication device 400 may include an Application Specific Integrated Circuit (ASIC) 410, an Application Specific Instruction set Processor (ASIP) 430, a memory 450, a main processor 470, and a main memory 490. At least two of the ASIC 410, the ASIP 430, and the main processor 470 may communicate with each other. At least two of the ASIC 410, the ASIP 430, the memory 450, a radio frequency integrated circuit (RFIC) 460, the main processor 470, and the main memory 490 may be embedded into one chip. For example, as described above, at least two of the ASIC 410, the ASIP 430, the memory 450, the main processor 470, and the main memory 490 may be included in one model chip. The wireless communication device 400 may further include the interference cancellation circuit described above with reference to FIGS. 1 through 11.

The ASIP 430 may be an integrated circuit customized for a use purpose. The ASIP 430 may support an instruction set only for a certain application and may execute instructions included in the instruction set. The memory 450 may communicate with the ASIP 430 and may store, as a non-transitory storage, the instructions executed by the ASIP 430. For example, as a non-limiting example, the memory 450 may include an arbitrary type of memory accessed by the ASIP 430, for example, Random Access Memory (RAM), Read Only Memory (ROM), a tape, a magnetic disk, an optical disk, a volatile memory, a non-volatile memory, and a combination thereof.

The main processor 470 may execute the instructions to control the wireless communication device 400. For example, the main processor 470 may control the ASIC 410 and the ASIP 430, and may process received data or process a user input to the wireless communication device 400. The main memory 490 may communicate with the main processor 470 and may store, as a non-transitory storage, the instructions executed by the main processor 470. For example, as a non-limiting example, the main memory 490 may include an arbitrary type of memory accessed by the main processor 470, for example, RAM, ROM, a tape, a magnetic disk, an optical disk, a volatile memory, a non-volatile memory, and a combination thereof.

A wireless communication device including the interference cancellation circuit according to the embodiment described above with reference to FIGS. 1 through 11, and an operation method of the wireless communication device may be performed by at least one of the components included in the wireless communication device 400 of FIG. 12. According to some embodiments, at least one operation of the operation method of the interference cancellation circuit described above may be implemented as a plurality of instructions stored in the memory 450. According to some embodiments, the ASIP 430 may perform at least one of the operations of the above-described operation method by executing the plurality of instructions stored in the memory 450.

In the interference cancellation circuit, the phase reconfiguration circuit is configured to output the interference phase by reconfiguring the respective phases of the one or more input signals to be identical to the phase of the kernel model.

In the interference cancellation circuit, based on the one or more input signals being one input signal, the interference model comprises a $2^{nd}$ harmonic and a $3^{rd}$ harmonic.

In the interference cancellation circuit, based on the interference model being the $3^{rd}$ harmonic, the phase reconfiguration circuit is configured to triple a function for the respective phases of the one or more input signals.

In the interference cancellation circuit, based on the one or more input signals comprising a first input signal and a second input signal, the interference model comprises intermodulation distortion 2 (IMD2), intermodulation distortion 3 (IMD3), intermodulation distortion 4 (IMD4), and intermodulation distortion 5 (IMD5).

In the interference cancellation circuit, the interference model comprises sub-interference models based on a combination of the first input signal, a first conjugate signal of the first input signal, the second input signal, and a second conjugate signal of the second input signal.

Various changes in form and detail may be made without departing from the scope of the following claims.

**Claims**

1. An interference cancellation circuit (300) comprising:

   a magnitude and phase calculator (311) configured to receive one or more input signals and calculate respective magnitudes and respective phases of the one or more input signals;
   a phase reconfiguration circuit (312) configured to output an interference phase by reconfiguring the respective phases of the one or more input signals, based on an interference model; and
   a weight estimator (320) configured to estimate a weight of an interference signal, based on the respective magnitudes of the one or more input signals,
   wherein the interference cancellation circuit (300) is configured to output the interference signal based on the interference phase, the respective magnitudes of the one or more input signals, and the weight, and
   wherein a phase of a kernel model associated with the interference model is different from the respective phases of the one or more input signals.

2. The interference cancellation circuit (300) of claim 1, wherein the phase reconfiguration circuit (312) is further configured to output the interference phase by reconfiguring the respective phases of the one or more input signals to be identical to the phase of the kernel model.

3. The interference cancellation circuit (300) of claim 1 or 2, wherein the weight comprises a plurality of segments, and wherein the weight estimator (320) is further configured to select an index for one of the plurality of segments corresponding to the respective magnitudes of the one or more input signals and, based on the index, determine the weight.

4. The interference cancellation circuit (300) of any preceding claim, wherein, based on the one or more input signals being one input signal, the interference model comprises a $2^{nd}$ harmonic and a $3^{rd}$ harmonic.

5. The interference cancellation circuit (300) of claim 4, wherein the phase reconfiguration circuit (312) is further configured to, based on the interference model being the $2^{nd}$ harmonic, double a function for the respective phases of the one or more input signals.

6. The interference cancellation circuit (300) of claim 4, wherein the phase reconfiguration circuit (312) is further configured to, based on the interference model being the $3^{rd}$ harmonic, triple a function for the respective phases of the one or more input signals.

7. The interference cancellation circuit (300) of any of claims 1 to 3, wherein, based on the one or more input signals comprising a first input signal and a second input signal, the interference model comprises intermodulation distortion 2, IMD2, intermodulation distortion 3, IMD3, intermodulation distortion 4, IMD4, and intermodulation distortion 5, IMD5.

8. The interference cancellation circuit (300) of claim 7, wherein the interference model comprises sub-interference models based on a combination of the first input signal, a first conjugate signal of the first input signal, the second input signal, and a second conjugate signal of the second input signal.

9. The interference cancellation circuit (300) of any preceding claim, further comprising a plurality of sub-interference cancellation circuits (300_0 - 300_(M-1)) having different memory orders,

   wherein a plurality of magnitude and phase calculators comprises the magnitude and phase calculator (311), wherein each of the plurality of sub-interference cancellation circuits (300_0 - 300_(M-1)) comprises: one magnitude and phase calculator (311_0) of the plurality of magnitude and phase calculators; the phase reconfiguration circuit (312); and the weight estimator (320), and is configured to output a sub-interference signal corresponding to a memory index, based on the interference phase, the respective magnitudes of the one or more input signals, and the weight, and
   wherein the interference cancellation circuit (300) is configured to output the interference signal by summing a plurality of sub-interference signals, each sub-interference signal of the plurality of sub-interference signals corresponding to a respective memory index.

10. The interference cancellation circuit (300) of claim 9, wherein the interference cancellation circuit (300) is further configured to delay the one or more input signals by an amount corresponding to the memory index and input a result of the delaying as the one or more input signals to the plurality of sub-interference cancellation circuits (300_0 - 300_(M-1)).

11. An operation method of an interference cancellation circuit (300), the operation method comprising:

    receiving (S101) one or more input signals;
    calculating respective magnitudes and respective phases of the one or more input signals;
    generating (S103) an interference phase by reconfiguring the respective phases of the one or more input signals, based on an interference model;
    estimating (S105) a weight of an interference signal, based on the respective magnitudes of the one or more input signals; and
    outputting (S107) the interference signal, based on the interference phase, the respective magnitudes of the one or more input signals, and the weight,
    wherein a phase of a kernel model associated with the interference model is different from the respective phases of the one or more input signals.

12. The operation method of claim 11, wherein the generating (S103) of the interference phase comprises generating the interference phase by reconfiguring the respective phases of the one or more input signals to be identical to the phase of the kernel model.

13. The operation method of claim 11 or 12, wherein the weight comprises a plurality of segments, and wherein the operation method further comprises:

    selecting an index for one of the plurality of segments corresponding to the respective magnitudes of the one or more input signals; and
    determining the weight, based on the index.

14. The operation method of any of claims 11 to 13, wherein, based on the one or more input signals being one input signal, the interference model comprises a $2^{nd}$ harmonic and a $3^{rd}$ harmonic.

15. The operation method of claim 14, wherein the generating (S103) the interference phase comprises, based on the interference model being the $2^{nd}$ harmonic, doubling a function for the respective phases of the one or more input signals.

# FIG. 1

**FIG. 2**

# FIG. 3

300

interference cancellation circuit

310

Reference generator

311

x(n) → Magnitude and phase calculator

312

Phase reconfiguration circuit

320

Weight estimator

321

Segment index selector

322

Weight selector

⊗ → y(n)

FIG. 4

# FIG. 5

| INTERFERENCE MODEL | $\theta_{var1}(n)$ |
|---|---|
| 2$^{nd}$ harmonic | $\theta_{var1}(n) = 2\theta(n)$ |
| 3$^{rd}$ harmonic | $\theta_{var1}(n) = 3\theta(n)$ |

# FIG. 6

# FIG. 7

| INTERFERENCE MODEL | | $\theta_{\text{var2}}(n)$ |
|---|---|---|
| IMD2_1 | $x_1(n)x_2(n) + |x_1(n)|^2 x_1(n)x_2(n)$ $+|x_2(n)|^2 x_1(n)x_2(n) + \cdots$ | $\theta_{var2}(n) = \theta_1(n) + \theta_2(n)$ |
| IMD2_2 | $x_1(n)x_2^*(n) + |x_1(n)|^2 x_1(n)x_2^*(n)$ $+|x_2(n)|^2 x_1(n)x_2^*(n) + \cdots$ | $\theta_{var2}(n) = \theta_1(n) - \theta_2(n)$ |
| IMD2_3 | $x_1^*(n)x_2(n) + |x_1(n)|^2 x_1^*(n)x_2(n)$ $+|x_2(n)|^2 x_1^*(n)x_2(n) + \cdots$ | $\theta_{var2}(n) = \theta_2(n) - \theta_1(n)$ |
| IMD3_1 | $x_1(n)\{x_2^*(n)\}^2 + |x_1(n)|^2 x_1(n)\{x_2^*(n)\}^2$ $+|x_2(n)|^2 x_1(n)\{x_2^*(n)\}^2 + \cdots$ | $\theta_{var2}(n) = \theta_1(n) - 2\theta_2(n)$ |
| IMD3_2 | $x_1(n)x^2(n) + |x_1(n)|^2 x_1(n)x^2(n)$ $+|x_2(n)|^2 x_1(n)x^2(n) + \cdots$ | $\theta_{var2}(n) = \theta_1(n) + 2\theta_2(n)$ |
| IMD3_3 | $x_1^2(n)x_2(n) + |x_1(n)|^2 x_1^2(n)x_2(n)$ $+|x_2(n)|^2 x_1^2(n)x_2(n) + \cdots$ | $\theta_{var2}(n) = 2\theta_1(n) + \theta_2(n)$ |
| IMD3_4 | $x_1^2(n)x_2^*(n) + |x_1(n)|^2 x_1^2(n)x_2^*(n)$ $+|x_2(n)|^2 x_1^2(n)x_2^*(n) + \cdots$ | $\theta_{var2}(n) = 2\theta_1(n) - \theta_2(n)$ |
| $\vdots$ | $\vdots$ | $\vdots$ |

# FIG. 8

# FIG. 9

300

300_(M-1)

m=M-1

m=1

300_1

m=0

300_0

AA2

y(n)

330 — D

330 — D

$x_1(n)$

311_0

$e^{j\theta_1(n-m)}$

312_0

Phase reconfiguration circuit

$e^{j\theta_{var2}(n-m)}$

MM3

Magnitude and phase calculator

$e^{j\theta_2(n-m)}$

$|x_1(n-m)|$

MM1

330 — D

330 — D

$x_2(n)$

311'_0

Magnitude and phase calculator

$|x_2(n-m)|$

MM2

AA1

$A_{klm}$

$B_{klm}$

$C_{klm}$

322_0

Weight selector

321_0

$|x_1(n)|$

$|x_2(n)|$

Segment index selector

$(k,l)$

$\beta_0,...,\beta_K$

$\gamma_0,...,\gamma_L$

# FIG. 10A

| INTERFERENCE TYPE | INTERFERENCE MODEL |
|---|---|
| H2 | $x^2(n)$ |
| IMD3 | $x_1^2(n)x_2^*(n)$ |
| IMD3+IMD5 | $x_1^2(n)x_2^*(n) + \lvert x_1(n)\rvert^2 x_1^2(n)x_2^*(n)$ |

# FIG. 10B

No TSIC

| | No ITF |
|---|---|
| | No TSIC |
| | MP+LS |
| | MSA+LS |

uncoded BER

No ITF, MP+LS, MSA+LS

SNR (dB)

# FIG. 10C

No TSIC

uncoded BER

No ITF,
MSA+LS

MP+LS

SNR (dB)

| | |
|---|---|
| —○— | No ITF |
| —□— | No TSIC |
| —◉— | MP+LS |
| --◇-- | MSA+LS |

# FIG. 10D

# FIG. 11

```
┌─────────────────────────────────────────────┐
│     RECEIVE ONE OR MORE INPUT SIGNALS,       │
│  AND CALCULATE RESPECTIVE MAGNITUDES AND     │── S101
│ RESPECTIVE PHASES OF ONE OR MORE INPUT SIGNALS│
└─────────────────────────────────────────────┘
                       │
                       ▼
┌─────────────────────────────────────────────┐
│ GENERATE INTERFERENCE PHASE BY RECONFIGURING │
│      PHASES OF ONE OR MORE INPUT SIGNALS,    │── S103
│         BASED ON INTERFERENCE MODEL          │
└─────────────────────────────────────────────┘
                       │
                       ▼
┌─────────────────────────────────────────────┐
│    ESTIMATE WEIGHT OF INTERFERENCE SIGNAL,   │
│ BASED ON MAGNITUDES OF ONE OR MORE INPUT SIGNALS│── S105
└─────────────────────────────────────────────┘
                       │
                       ▼
┌─────────────────────────────────────────────┐
│         OUTPUT INTERFERENCE SIGNAL,          │
│ BASED ON INTERFERENCE PHASE, MAGNITUDES OF ONE│── S107
│      OR MORE INPUT SIGNALS, AND WEIGHT       │
└─────────────────────────────────────────────┘
```

# FIG. 12

Wireless Communication Device (400)

- ASIC (410)
- ASIP (430)
- Memory (450)
- RFIC (460)
- Main Processor (470)
- Main Memory (490)
- Ant

Europäisches
Patentamt

European
Patent Office

Office européen
des brevets

# EUROPEAN SEARCH REPORT

**Application Number**

EP 25 20 6292

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2015/311929 A1 (CARBONE NICHOLAS MICHAEL [US] ET AL) 29 October 2015 (2015-10-29) * figure 2 * * paragraphs [0033] - [0037] * ----- | 1-11 | INV. H04B1/525 |
| X | EP 4 387 111 A1 (SAMSUNG ELECTRONICS CO LTD [KR]) 19 June 2024 (2024-06-19) * abstract; figure 2A * * paragraphs [0019] - [0023], [0034] - [0040] * ----- | 1-11 | |
| X | EP 4 369 615 A1 (SAMSUNG ELECTRONICS CO LTD [KR]) 15 May 2024 (2024-05-15) * figures 2, 5 * * paragraphs [0015] - [0025] * ----- | 1-15 | |
| X | EP 3 273 606 A1 (INTEL CORP [US]) 24 January 2018 (2018-01-24) * the whole document * ----- | 1-15 | |

**TECHNICAL FIELDS SEARCHED (IPC)**

H04B

The present search report has been drawn up for all claims

| Place of search | Date of completion of the search | Examiner |
|---|---|---|
| Munich | 3 March 2026 | Almenar Muñoz, M |

EPO FORM 1503 03.82 (P04C01)

## ANNEX TO THE EUROPEAN SEARCH REPORT
## ON EUROPEAN PATENT APPLICATION NO.

EP 25 20 6292

This annex lists the patent family members relating to the patent documents cited in the above-mentioned European search report.
The members are as contained in the European Patent Office EDP file on
The European Patent Office is in no way liable for these particulars which are merely given for the purpose of information.

03-03-2026

| Patent document cited in search report | | Publication date | Patent family member(s) | | Publication date |
|---|---|---|---|---|---|
| US 2015311929 | A1 | 29-10-2015 | NONE | | |
| EP 4387111 | A1 | 19-06-2024 | CN | 118214450 A | 18-06-2024 |
| | | | EP | 4387111 A1 | 19-06-2024 |
| | | | KR | 20240093216 A | 24-06-2024 |
| | | | US | 2024204977 A1 | 20-06-2024 |
| EP 4369615 | A1 | 15-05-2024 | EP | 4369615 A1 | 15-05-2024 |
| | | | US | 2024179033 A1 | 30-05-2024 |
| EP 3273606 | A1 | 24-01-2018 | CN | 107645316 A | 30-01-2018 |
| | | | EP | 3273606 A1 | 24-01-2018 |
| | | | US | 2018026775 A1 | 25-01-2018 |
| | | | US | 2019229884 A1 | 25-07-2019 |
| | | | US | 2023344614 A1 | 26-10-2023 |
| | | | WO | 2018017143 A2 | 25-01-2018 |

EPO FORM P0459

For more details about this annex : see Official Journal of the European Patent Office, No. 12/82